(19)

Europäisches
Patentamt
European
Patent Office
Office européen
des brevets

(11) **EP 3 428 661 A1**

(12) **EUROPEAN PATENT APPLICATION**

(43) Date of publication:
**16.01.2019 Bulletin 2019/03**

(21) Application number: **17020307.9**

(22) Date of filing: **13.07.2017**

(51) Int Cl.:
***G01R 15/18*** (2006.01)    ***H03K 5/007*** (2006.01)
***G01R 15/20*** (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **Bergoz Instrumentation
01630 Saint-Genis-Pouilly (FR)**

(72) Inventor: **Stulle, Frank
1214 Vernier (CH)**

(54)    **DEVICE FOR AVERAGE CURRENT MEASUREMENTS OF PULSED ELECTRICAL SIGNALS**

(57)    We describe a device that allows the accurate and high-resolution contactless determination of the average current of continuous pulsed electrical signals (1). The output voltage (8) is independent of the input pulse shape (1). Pulse repetition periods can be as low as nanoseconds. Noise contributions are well suppressed. The device consists of a wide-band current transformer (2), which inductively couples to the input signal's magnetic field thus providing some signal (3), and analog electronics incorporating a high-pass filter (4), a low-pass filter (5), fast sample-and-hold electronics (6) for signal analysis and another low-pass filter (7). The output signal (8) of the device is a voltage proportional to the average input current. By proper choice of the filter cut-off frequencies noise reduction and output bandwidth can both be maintained at very good levels. In particular, high-pass filter (4) and low-pass filter (7) shall have the same or at least very similar cut-off frequencies. The described device is applicable in fields as diverse as, for example, industrial applications like power supplies of pulsed X-Ray sources and research applications like the particle beam of particle accelerators.

Figure 1

EP 3 428 661 A1

## Description

Field of the Invention

The invention relates to devices based on current transformers which are used for accurate and high-resolution contactless average current measurements of pulsed electrical signals.

The current transformer's output signal is treated by fast analog electronics to obtain a voltage proportional to the average input current. By adapting current transformer and electronics parameters, the device can be optimized to a wide range of pulse repetition periods, which may be as low as nanoseconds. The described device is applicable in fields as diverse as, for example, industrial applications like pulsed X-Ray sources and research applications like the particle beam of particle accelerators.

Background

Measuring the current of electrical signals is a standard requirement for monitoring electrical or electronic devices. Often non-disturbing, contactless measurement devices will be required to preserve signal integrity.

Standard devices used for contactless average current measurements include among others flux-gate magnetometers [1,2] or Hall effect magnetometers [3,4]. Such devices tend to be slow or sensitive to external magnetic fields and temperature variations. Only for time-varying input signals passive current transformers can be used.

The basic principle of a flux-gate magnetometer is to use a ring-shaped magnetic core with two separated windings. The first winding is periodically excited by strong current pulses of alternating sign. This current drives the magnetic core into alternating positive and negative saturation. Additionally, a signal is induced in the second winding, which is the output signal. If no external magnetic field is present, this output signal will be symmetric.

But in the presence of an external magnetic field, said output signal becomes asymmetric.

The strength of the asymmetry is a measure of the external magnetic field amplitude. If the external magnetic field is created by an external current passing the magnetic core's aperture, the output signal's asymmetry is a measure of the external current's average amplitude.

For such a flux-gate magnetometer the speed with which variations of the external current can be sampled is limited by the period of the saturating current pulses. Additionally, the output signal strongly depends on the magnetic properties of the magnetic core, which themselves depend on temperature.

Hall effect magnetometers consist of a Hall probe placed in the gap of a magnetic core. The current to-be-measured passes the magnetic core aperture and induces a magnetic flux in the magnetic core and the gap. This magnetic flux is sensed by the Hall probe. Similar magnetometers might be based on magnetic flux probes of a different type, e.g. tunneling magneto resistive probes [5,6].

In such magnetometers, the magnetic flux probe senses only the magnetic flux at one location around the magnetic core circumference, i.e. inside the gap. Thus, external magnetic fields, i.e. magnetic fields not created by currents passing the core aperture, can induce an erroneous signal in the probe. Furthermore, the amplitude of the magnetic flux in the gap of the magnetic core will depend on the magnetic properties of the core, which themselves depend on temperature.

As a consequence of the laws of physics, usual passive current transformers are capable of measuring AC currents only, which renders their application to AC signals straight forward.

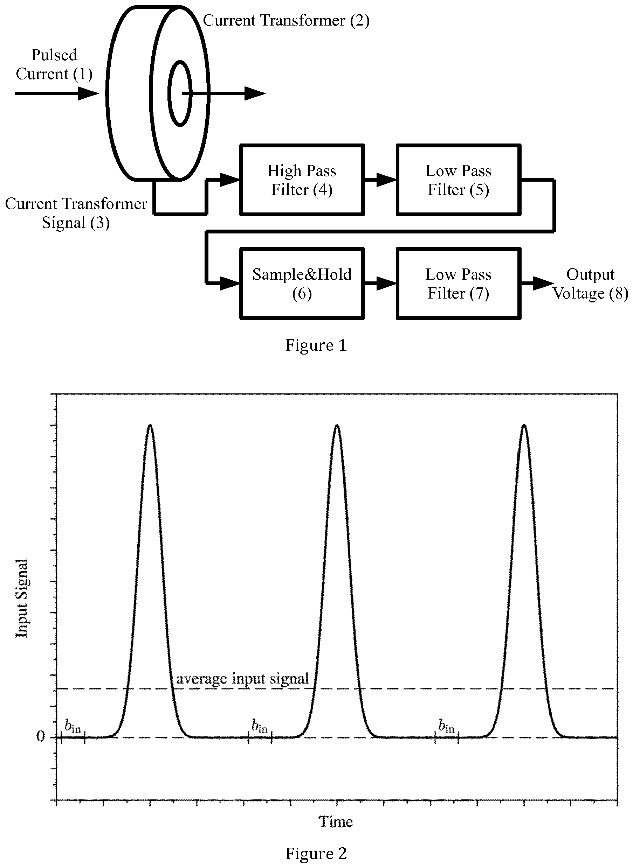

But their application to signals containing DC components requires the exploitation of a-priori knowledge of the input signal and the current transformer's response function. A widely applicable assumption is that the input signal consists of well-separated pulses. Between any two consecutive pulses the input signal shall fall to zero (Figure 2).

Concerning such signals, a huge variety of solutions have been invented relating to the so-called baseline or DC restoration of current transformer output signals (a few examples are given in the patent references, see below). They all aim at modifying a current transformer's output signal in a way that it resembles more closely the input signal including its DC component. This modified signal is then used for further analysis.

While such an approach is appropriate for some kinds of measurements, it adds some complication unnecessary for the contactless measurement of the average current of said type of input signals. A simple, but accurate device which shows little susceptibility to signal shape and environmental influences is desirable.

Brief Summary of the Invention

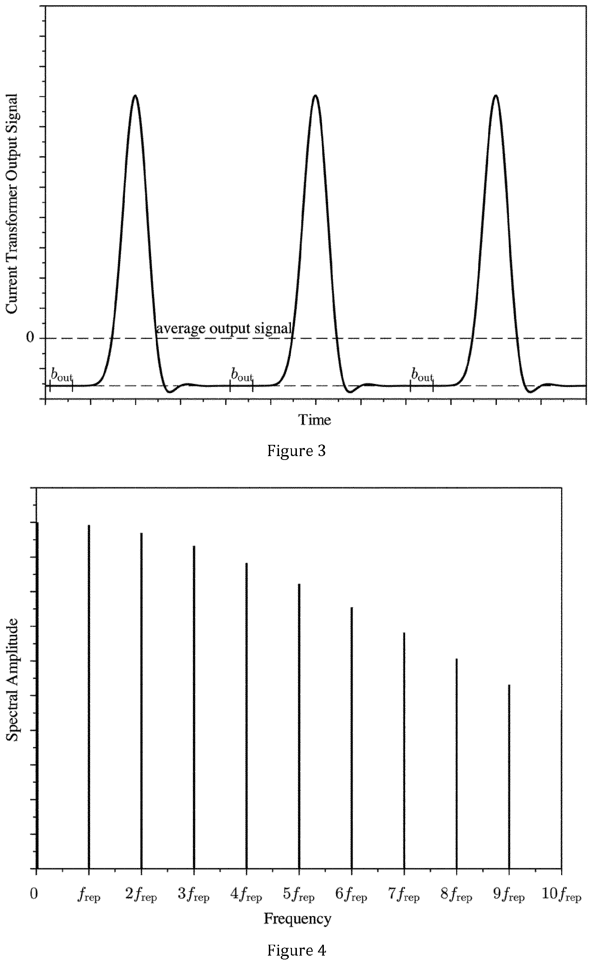

The present invention is based on above described application of current transformers for average current measurements. But it differs from prior art by not aiming at modifying signals. The invention exploits the fact that for said input signals sufficient information for average input current deduction is present in the current transformer output signal as is (Figure 3). Hence, to perform such measurements the measurement device can be simplified considerably.

A current transformer that inductively couples to the input current is combined with some analog electronics which filters the current transformer output signal and samples its baseline. Except for a fixed gain factor, the sampled baseline is a direct measure of the input signal's average current.

Here the term "baseline" is used to describe the value of a pulsed signal in between consecutive pulses. For the input signal, it shall equal zero (Figure 2). For the current transformer output signal, it shall denote the value when the input signal is zero and any signal deformations possibly induced by the current transformer have vanished (Figure 3).

Brief Description of the Figures

Figure 1 is a schematic illustration of the device's functional blocks and the signal path.

Figure 2 illustrates the to-be-measured input signal (1) in time-domain. The input signal consists of a continuous stream of individual pulses with a certain average value $\langle I_{in}(t)\rangle$. Amplitudes and lengths of individual pulses may vary. But in between any two consecutive pulses the input signal shall fall to zero. That means, its baseline shall be at $b_{in} = 0$.

Figure 3 illustrates the output signal (3) of the current transformer (2). Depending on its turns-ratio and its load impedance, the current transformer (2) will scale the input signal by a gain factor $g_{CT}$. Following general transformer characteristics, DC and very low frequency signals are not transmitted. Thus, a generally time-varying offset is induced because the average output signal must tend to zero. That means, the output signal's baseline will be at $b_{out}(t)$. For an input stream of equal pulses, the average output signal $\langle I_{out}(t)\rangle$ will equal zero and $b_{out}(t)$ will be a constant non-zero value.

Figure 4 illustrates the amplitude spectrum of a stream of equal input pulses (1). Only individual spectral rays at 0, the pulse repetition frequency $f_{rep}$ and harmonics are present. The amplitudes depend on the shape of the input pulses (1).

Figure 5 illustrates the amplitude spectrum of a stream of time-varying input pulses (1). Pulse-to-pulse variations might broaden the spectral rays and add side-bands. These side-bands are of equal shape around all spectral rays. Their amplitude is scaled by the corresponding spectral ray's amplitude.

Figure 6 illustrates the current transformer (2) response function in frequency-domain. The current transformer's lower cut-off frequency $f_{low}$ shall be considerable lower than the pulse repetition frequency $f_{rep}$.

Detailed Description of the Invention

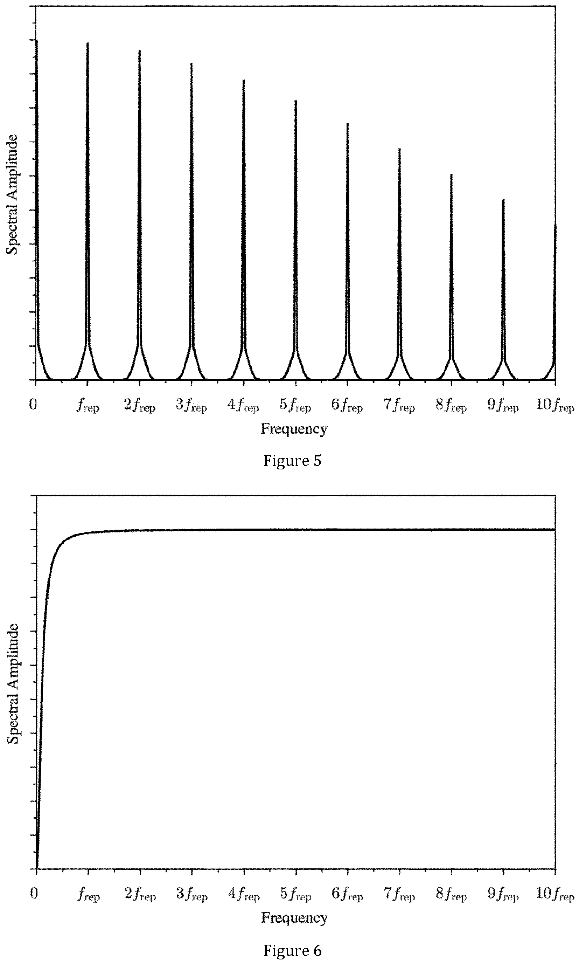

Based on the laws of mathematics, most notably the Fourier transform, it can be shown that any repetitive stream of equal, well-separated pulses, in this case electrical current pulses, corresponds to a frequency spectrum containing only individual rays at zero, the pulse repetition frequency and its harmonics (Figure 4). Pulse-to-pulse fluctuations create equally-shaped sidebands around all these rays. The side-band amplitudes are linked to the amplitude of the corresponding ray (Figure 5). Consequently, except for the amplitude at zero there is no unique information in the spectral range below the pulse repetition frequency.

Following Maxwell's equations, a transformer has a frequency response of

$$i_{out}(f) = g_{CT}\, i_{in}(f)\, \frac{1}{\dfrac{Z_2}{i\, 2\pi\, f\, L_2} + 1},$$

which equals the frequency response of a normal first-order high-pass filter of lower cut-off frequency

$$f_{low} = \frac{1}{2\pi}\frac{Z_2}{L_2}.$$

The spectral amplitudes of input and output currents are denoted by $i_{in}(f)$ and $i_{out}(f)$, respectively. $g_{CT}$ is the transformer gain which depends among others on the transformer turns ratio $N_1/N_2$. $Z_2$ is the impedance of the electrical load on the transformer's secondary side. $L_2$ is the inductance of the transformer's secondary winding. For $f = 0$ above equation results zero.

When using a current transformer (2) with an $f_{low}$ considerably below the pulse repetition frequency to measure above described pulsed input currents (1), the only information of interest that is lost corresponds to a constant baseline offset (Figure 6). Knowing a-priori that the input signal (1) shall fall to zero between any two consecutive pulses, such a baseline offset can be corrected. This is what is done in prior art, for example, by calculating the difference of the output signal and the deduced baseline.

The baseline signal $I_{base}(t)$ is acquired by measuring over short time spans the current transformer output signal $I_{out}(t)$ (3). In between these samples, the baseline can be considered constant (Figure 2).

Going a step further in analysis, it can be shown that the baseline $I_{base}(t)$ is a low-pass filtered and scaled representation of the input signal $I_{in}(t)$. In frequency-domain we can write:

$$g_{CT}\, i_{in}(f) = i_{out}(f) - i_{base}(f).$$

Considering that $i_{out}(f)$ was already identified as acting like a first-order high-pass filter, we can directly deduce that $i_{base}(f)$ must act like a first-order low-pass

filter:

$$i_{\text{base}}(f) = -g_{\text{CT}}\, i_{\text{in}}(f)\; \frac{1}{\dfrac{i\, 2\pi\, f\, L_2}{Z_2} + 1}.$$

Due to the linearity of the Fourier transform it follows that in time-domain

$$g_{\text{CT}}\, I_{\text{in}}(t) = I_{\text{out}}(t) - I_{\text{base}}(t).$$

$I_{\text{base}}(t)$ contains not only the information about the average value of $I_{\text{in}}(t)$ but also the information about slow fluctuations of $I_{\text{in}}(t)$ up to a frequency of $f_{\text{low}}$. That means, measuring $I_{\text{base}}(t)$ is sufficient for the deduction of the average input current. Baseline restoration is not necessary:

$$\langle I_{\text{in}}(t) \rangle = -\frac{1}{g_{\text{CT}}} I_{\text{base}}(t).$$

To avoid a measurable, thus detrimental to accuracy, drift of the baseline between two consecutive pulses, the lower cut-off frequency $f_{\text{low}}$ of the current transformer (2) shall be considerably below the pulse repetition frequency $f_{\text{rep}}$ of the input signal (1).

The disclosed invention exploits said findings to achieve a simple yet accurate and high-resolution device for the measurement of the average current of said pulsed input signals.

It is important to note that above deduction does not exploit any characteristics special to current transformers. Any signal source that provides high-pass filtered signals would allow an equivalent deduction. Hence, the current invention shall cover also such cases, even though most parts of this text are limited to the discussion of current transformers.

The preferred implementation of the invention consists of the following parts. A current transformer (2) whose lower cut-off frequency $f_{\text{low}}$ is considerably below the pulse repetition frequency $f_{\text{rep}}$ of the input signal (1). To avoid detrimental deformations of the baseline, $f_{\text{low}}$ shall be at least a hundred times smaller than $f_{\text{rep}}$. The upper cut-off frequency of the current transformer (2) shall be high enough to resolve the individual pulses of the input signal (1). A high-pass filter (4) eliminating any unwanted low frequency contributions below $f_{\text{low}}$, e.g. power line noise, and a low-pass filter (5) eliminating any signals of unnecessarily high frequency prior to further signal treatment.

After this filtering, some sample-and-hold electronics (6) shall measure the current transformer output signal (3) over short time steps in between any two consecutive pulses and hold the measured values until the next cycle. The sampling time shall be short enough to only sample the baseline, but not previous or following pulse signals. The output signal of the sample-and-hold electronics (6) will be a piecewise constant representation of the baseline of the current transformer output signal (3). In frequency-domain, only the spectral contributions below $f_{\text{low}}$ represent the baseline. Spectral contributions above $f_{\text{low}}$ are artifacts of the sampling. They shall be removed by applying low-pass filter (7).

By choosing the same or at least very similar cut-off frequencies for the high-pass filter (4) and the low-pass filter (7) noise contributions present in the current transformer signal (3) will be reduced at almost any frequency. Remaining noise contributions are due to the aliasing of the noise in a narrow band around $f_{\text{rep}}$ and the low frequency noise contributions of the sample-and-hold electronics. Consequently, the device has very high resolution.

As a variant, said cut-off frequencies may be higher than the lower cut-off frequency $f_{\text{low}}$ of the current transformer (2) to increase output signal bandwidth.

The preferred, but not exclusive, solution is to integrate the filters and the sample-and-hold electronics on one electronics board, forming some complete signal analyzing electronics.

The resulting output voltage (8) may be detected by some voltage sensitive diagnostics device with sufficient resolution, dynamic range and measurement rate, for example, a voltmeter, oscilloscope or digitizer. A fixed, factory-measured gain factor will need to be applied to obtain the average input current.

The current transformer (2) and the signal analyzing electronics shall be connected by a coaxial cable of a length required by the physical installation.

References

Patents

US9118305, Jeffries B.P., Derounian P., "DC restoration for synchronization signals", 2015-08-25
US4125812, Polonio, J.D., "Apparatus for baseline restoration in an AC-coupled signal", 1978-11-14
US3463940, Field G.C., Kaye A.R., "D.c. restoration circuit", 1969-08-26
US 20160301399, Maeding, D.G., "Baseline Restore Sampling Method", 2016-10-13

Other Publications

[1] Snare, R.C. (1998), "A History of Vector Magnetometry in Space", in Pfaff, R.F., Borovsky, J.E., Young, D.T. eds., "Measurement Techniques in Space Plasmas Fields", American Geophysical Union, Washington, D. C.,

[2] Musmann, G. (2010), "Fluxgate Magnetometers for Space Research", Books on Demand, Norderstedt

[3] Ramsden, E. (2006), "Hall-Effect Sensors: Theory and Applications", Elsevier, Oxford

[4] Popovic, R.S. (2004), "Hall Effect Devices", CRC Press, Boca Raton

[5] Julliere, M. (1975), "Tunneling between ferromagnetic films", Phys. Lett. A, vol. 54 issue 3, pp. 225-226, Elsevier

[6] Miyazaki T., Tezuka N. (1995), "Giant magnetic tunneling effect in Fe/A1203/Fe junction", J. Magn. Magn. Mater., vol. 139, issue 3, pp. L231-L234, Elsevier

**Claims**

1. A device for accurate, high-resolution average current measurements of pulsed electrical input signals which is based on a current transformer and some analog electronics, said device comprising:

   A passive current transformer (2) made of a magnetic core of a given permeability and cross-section and a secondary winding wound on said magnetic core, which inductively couples to the input signal (1), terminated by a load resistance. The parameters of said current transformer (2), its core permeability, cross-section and number of secondary winding turns, shall be adjusted so that its lower cut-off frequency becomes considerably, at least a factor 100, lower than the repetition frequency of the input signal (1).
   A cable that allows the remote connection of some signal analyzing electronics to said current transformer (2).
   Some signal analyzing electronics connected to that cable for processing the output signal (3) of said current transformer (2).
   Said signal analyzing electronics comprising at its input a high-pass filter (4) and a low-pass filter (5) limiting the signal to the required input bandwidth, some sample-and-hold electronics (6) measuring the signal's baseline in between any two consecutive pulses and a low-pass filter (7) limiting the sampled baseline signal to the required output bandwidth.
   The upper cut-off frequency of the low-pass filter (5) shall be adjusted to a value at least three times the pulse repetition frequency.
   The lower cut-off frequency of the high-pass filter (4) shall be adjusted to a value at least a factor 100 lower than the pulse repetition frequency of the input signal (1).
   The lower cut-off frequency of the low-pass filter (7) shall be equal or at least very similar to the upper cut-off frequency of the high-pass filter (4).

2. The input signal (1) shall pass the aperture of the current transformer (2), which is part of the device described in claim 1, on a simple wire, in case the input signal (1) is an electrical signal, or as freely moving charges in air or vacuum, in case the input signal (1) is a beam of a particle accelerator.

3. The output voltage (8) of the device described in claim 1 shall be detected by some voltage sensitive diagnostics device with sufficient resolution, dynamic range and measurement rate, for example, a voltmeter, oscilloscope or digitizer.

4. The device described in claim 1 may be extended by additional output amplifiers or attenuators adapting the levels of the output voltage (8) to levels compatible with the requirements of the voltage sensitive diagnostics device.

5. The device described in claim 1 may be extended by additional input amplifiers or attenuators adapting the levels of the current transformer signal (3) to levels compatible with the requirements of the sample-and-hold electronics (6).

6. To increase the bandwidth of the output signal (8) of the device described in claim 1, the lower cut-off frequency of the high-pass filter (4) and the upper cut-off frequency of the low-pass filter (7) may be above the lower cut-off frequency of the current transformer (2). The upper cut-off frequency of the low-pass filter (7) shall remain equal or at least very similar to the upper cut-off frequency of the high-pass filter (4).

7. In case the lower cut-off frequency of the current transformer (2), as required by the device described in claim 1, cannot be practically reached with a passive current transformer, some active electronics may be connected to said passive current transformer that effectively lowers its lower cut-off frequency to the required value. The signal analyzing electronics shall be connected to the output of this active electronics.

8. The current transformer (2) as used in claim 1 may also be replaced by some other device coupling to the input current (1) and providing an output signal similar to the current transformer signal (3).

9. The sample-and-hold electronics (6) as used in claim 1 may be adjusted to not measure the baseline between any two consecutive pulses. Instead it may skip some baseline values if such a setup provides advantages, for example in case of very high pulse repetition rates.

Figure 1

Figure 2

Figure 3

Figure 4

Figure 5

Figure 6

**EP 3 428 661 A1**

Europäisches
Patentamt

European
Patent Office

Office européen
des brevets

# EUROPEAN SEARCH REPORT

Application Number

EP 17 02 0307

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CA 2 266 534 A1 (PMC SIERRA LTD [CA]) 30 March 2000 (2000-03-30) * page 1, line 17 - page 13, line 25 * ----- | 1-9 | INV. G01R15/18 H03K5/007 G01R15/20 |
| X | US 3 667 056 A (ALLINGTON ROBERT W ET AL) 30 May 1972 (1972-05-30) * column 1, line 19 - line 70 * ----- | 1-9 | |
| X | US 4 491 799 A (GIARDINELLI SILVANO C [IT]) 1 January 1985 (1985-01-01) * column 5, line 41 - line 53 * ----- | 1-9 | |
| A | US 4 641 324 A (KARSH HERBERT [US] ET AL) 3 February 1987 (1987-02-03) * column 3, line 65 - column 4, line 60 * ----- | 1-9 | |
| | | | TECHNICAL FIELDS SEARCHED (IPC) G01R H03K |

| The present search report has been drawn up for all claims | | |
|---|---|---|
| Place of search | Date of completion of the search | Examiner |
| Munich | 26 January 2018 | Jedlicska, István |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 17 02 0307

This annex lists the patent family members relating to the patent documents cited in the above-mentioned European search report.
The members are as contained in the European Patent Office EDP file on
The European Patent Office is in no way liable for these particulars which are merely given for the purpose of information.

26-01-2018

| Patent document cited in search report | | Publication date | Patent family member(s) | | Publication date |
|---|---|---|---|---|---|
| CA 2266534 | A1 | 30-03-2000 | CA 2266534 A1 | | 30-03-2000 |
| | | | US 6408032 B1 | | 18-06-2002 |
| US 3667056 | A | 30-05-1972 | DE 2150153 A1 | | 31-05-1972 |
| | | | FR 2101797 A5 | | 31-03-1972 |
| | | | GB 1345720 A | | 06-02-1974 |
| | | | US 3667056 A | | 30-05-1972 |
| US 4491799 | A | 01-01-1985 | DE 3273910 D1 | | 27-11-1986 |
| | | | EP 0067796 A1 | | 22-12-1982 |
| | | | IT 1136739 B | | 03-09-1986 |
| | | | US 4491799 A | | 01-01-1985 |
| US 4641324 | A | 03-02-1987 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9118305 B, Jeffries B.P., Derounian P.
- US 4125812 A, Polonio, J.D.
- US 3463940 A, Field G.C., Kaye A.R.
- US 20160301399 A, Maeding, D.G.

**Non-patent literature cited in the description**

- A History of Vector Magnetometry in Space. **SNARE, R.C.** Measurement Techniques in Space Plasmas Fields. American Geophysical Union, 1998
- Fluxgate Magnetometers for Space Research. **MUSMANN, G.** Books on Demand. 2010
- **RAMSDEN, E.** Hall-Effect Sensors: Theory and Applications. Elsevier, 2006
- **POPOVIC, R.S.** Hall Effect Devices. CRC Press, 2004
- Tunneling between ferromagnetic films. **JULLIERE, M.** Phys. Lett. A. Elsevier, 1975, vol. 54, 225-226
- Giant magnetic tunneling effect in Fe/A1203/Fe junction. **MIYAZAKI T. ; TEZUKA N.** J. Magn. Magn. Mater. Elsevier, 1995, vol. 139, L231-L234